# EUROPÄISCHE PATENTSCHRIFT

(11) **EP 4 165 493 B1**
(45) Veröffentlichungstag und Bekanntmachung des Hinweises auf die Patenterteilung: **20.05.2026**
(21) Anmeldenummer: 21742311.0
(22) Anmeldetag: 24.06.2021
(51) Int. Cl.: G06F 3/042

(54) **DETEKTORSYSTEM**
DETECTOR SYSTEM
SYSTÈME DE DÉTECTEUR

(30) Priorität: 30.07.2020 DE 102020120158
(43) Veröffentlichungstag der Anmeldung: 19.04.2023
(73) Patentinhaber: Carl Zeiss Jena GmbH, 07745 Jena (DE)
(72) Erfinder: THOM, Martin, 07745 Jena (DE); JUNGHANS, Marc, 07745 Jena (DE); KLEINDIENST, Roman, 07745 Jena (DE); RIETHMÜLLER, Mirko, 07745 Jena (DE)
(74) Vertreter: Patentanwälte Geyer, Fehners & Partner mbB
(86) Internationale Anmeldenummer: PCT/EP2021/067330
(87) Internationale Veröffentlichungsnummer: WO 2022/022903

(56) Entgegenhaltungen:
- EP-A1- 3 129 866
- WO-A2-2014/137754
- DE-A1- 102018 209 305
- US-A1- 2011 248 960
- US-A1- 2014 192 023
- US-A1- 2015 103 051
- US-A1- 2017 255 813

## Beschreibung

Die vorliegende Erfindung betrifft ein Detektorsystem für eine Anzeigevorrichtung, wobei das Detektorsystem eine berührungslose Eingabeschnittstelle bereitstellt.

Anzeigeeinrichtungen werden heutzutage häufig so bereitgestellt, dass über ihre Oberfläche Eingaben getätigt werden können. Diese Funktionalität ist allgemein als "Touchscreen" bekannt und dient zur besseren Bedienbarkeit der Anzeigeeinrichtung. Des Weiteren kann auf zusätzliche Human-Machine-Interfaces (HMI), wie z.B. Maus oder Tastatur, verzichtet werden. Die Touchscreen-Technologie ist mittlerweile weit verbreitet und beispielsweise in Laptops, Point of Sale Systemen, Smartphones oder Multifunktionsdisplays von Fahrzeugen verbaut.

Es gibt derzeit drei übliche Lösungen für Touchscreens. So gibt es resistive Touchscreens, bei denen das Display auf Druck oder Widerstand reagiert. Der Druckpunkt wird durch eine Widerstandsmatrix aufgenommen, im Controller verarbeitet und vom Betriebssystem als Eingabe interpretiert.

Bei induktiven Touchscreens erfolgt die Bedienung meist mit einem Stift, an dessen Kopf eine Spule integriert ist. Durch ein Netz mit Leiterbahnen auf dem Display wird Strom in die Spule des Stiftes induziert. Der Stift sendet ein Signal aus, mit dem die genaue Position erkannt wird. Der Stift muss dafür selbst nicht die Oberfläche des Touchscreens berühren.

Bei kapazitiven Touchscreens kann das Display mit allen leitenden Gegenständen bedient werden. Solche kapazitiven Touchscreens werden derzeit in fast allen neuen Smartphones verbaut. Bei solchen kapazitiven Touchscreens ist in den Glasschichten ein Gitter aus Leiterbahnen integriert. Bei Berührung der Displayoberfläche verändert man das elektrische Feld. Über Kapazitätsänderungen im Gitter kann auf den Berührungspunkt geschlossen werden. Kapazitive Touchscreens sind multitouch-fähig. Das bedeutet, dass gleichzeitig mehr als ein Berührungspunkt erkannt und verarbeitet werden kann.

Bei graphischen Anwendungen ist weiterhin ein Trend in Richtung Augmented Reality (erweiterte Realität) zu erkennen. Hierunter versteht man insbesondere die computergestützte Erweiterung der Realitätswahrnehmung. Dabei erfolgt eine visuelle Darstellung von Informationen (z.B. Bildinhalten, virtuelle Objekte) mittels Einblendung und/oder Überlagerung in das reale Bild. Es gibt derzeit Bemühungen nach Bedienkonzepten für Augmented Reality-Lösungen. Die Steuerung/Eingabe basiert aktuell auf drei wesentlichen Ansätzen.

So kann eine Gestenerkennung durchgeführt werden. Hierbei werden Systeme mit einer externen Sensorik eingesetzt, um menschliche Gesten zu erkennen und computergestützt interpretieren zu können. Die am häufigsten verwendeten Methoden sind kamerabasierte Gestenerkennung, ultraschallbasierte Gestenerkennung, LIDAR (Light Detection and Ranging) sowie RADAR (Radio Detection and Ranging).

Bei der kamerabasierten Gestenerkennung werden eine oder mehrere Kameras genutzt, um Bilder der Gesten aufzunehmen. Diese werden dann über eine Software (Deskriptor) mit einer Datenbank verglichen und interpretiert. Diese Kameras können mit verschiedenen Technologien funktionieren, wie z.B. Time-of-Flight, Structured Light oder Stereoskopie.

Bei der ultraschallbasierten Gestenerkennung werden durch einen Mikrochip hochfrequente Schallwellen erzeugt, welche durch ein Objekt reflektiert werden. Die reflektierten Wellen können anschließend wieder vom Chip eingefangen werden. Über Laufzeit, Phasen- und/oder Frequenzverschiebung kann die Position und Bewegungsrichtung erkannt werden.

Beim LIDAR-Verfahren werden über die Messung der Laufzeiten von ausgesendeten Lichtsignalen die Entfernungen gemessen. Beim RADAR-Verfahren wird basierend auf der Messung der Laufzeit von ausgesendete und am Objekt reflektierten elektromagnetischen Wellen eine Entfernungs- und Richtungsbestimmung durchgeführt.

Ferner ist eine weit verbreitete Methode, um graphische Augmented Reality-Lösungen zu steuern, die Verwendung eines HMI (Human-Machine Interface). Als Beispiel kann der Ring mit Joystick "Loop" der Datenbrille "Focals" angegeben werden. Die Schnittstelle gibt die durch den Benutzer eingegebenen Befehle an das Betriebssystem zur Verarbeitung weiter.

Ferner kann eine Sprachsteuerung durchgeführt werden. Hier werden Befehle per Stimme an ein Modul übermittelt, welches die sprachliche Eingabe aufnehmen und interpretieren kann.

Die oben genannten derzeitigen Bedienkonzepte weisen jedoch einige Nachteile auf.

Bei den Touchscreen-Technologielösungen verschmutzt des Display durch das Berühren der Displayoberfläche, wodurch es zur Beeinträchtigung der Funktionalität kommen kann. Besonders im öffentlichen Raum (z.B. im Restaurant) oder in medizinischen Einrichtungen besteht auch eine Hygieneproblematik. Ferner können Kratzer auf der Displayoberfläche Störungen bei der Bedienung hervorrufen. Bei der kapazitiven Lösung muss die Eingabe durch ein leitfähiges Objekt erfolgen. Dies ist z.B. beim Tragen von Handschuhen umständlich oder unmöglich. Auch können Flüssigkeiten auf der Oberfläche das Bedienverhalten stören. Bei der resistiven Lösung muss die Oberfläche aus elastischem Stoff (z.B. Kunststoff) bestehen, wodurch das Display leicht kratzanfällig ist. Bei der induktiven Lösung ist ein eigenes HMI-Gerät notwendig (z.B. Stift).

Bei der Augmented Reality Steuerung besteht die Problematik, dass Sprachsteuerungen nur für die hinterlegten Sprachen funktionieren und störanfällig bezüglich Hintergrundgeräuschen sind. Die Eingabe über ein HMI erfordert zwingend ein zusätzliches Gerät, das HMI selbst. Die Gestenerkennung ist nur für bestimmte Lichtverhältnisse effektiv ausgelegt und ist abhängig von der Auflösung der Kamera sowie der Rechenleistung des Computersystems.

Ferner ist die WO 2014/137754 A2 bekannt, die ein Verfahren zur Erkennung einer berührungslosen Eingabe oberhalb einer Oberfläche beschreibt, bei dem holographische Elemente zur Einkopplung von Licht in einen Lichtwellenleiter verwendet werden.

Ausgehend hiervon ist es daher Aufgabe der Erfindung, ein Detektorsystem mit einer verbesserten Eingabeschnittstelle bereitzustellen. Die Erfindung wird durch das Detektorsystem gemäß Anspruch 1 definiert. Vorteilhafte Ausgestaltungen sind in den abhängigen Ansprüchen angegeben.

Das erfindungsgemäße Detektorsystem kann einen Wellenleiter, der einen transparenten Basiskörper mit einer Vorderseite und einer Rückseite aufweist, eine Anzeigeeinrichtung, die mehrere Auswahlbereiche so darstellt, dass sie in einem Anzeigebereich des Basiskörpers bei Betrachtung der Vorderseite wahrnehmbar sind, eine Sensoreinrichtung, die für jeden Auswahlbereich einen zugeordneten Sensorabschnitt aufweist, und eine Steuereinrichtung aufweisen. Der Basiskörper kann ein diffraktives Element im Anzeigebereich und einen vom Anzeigebereich beabstandeten Auskoppelbereich umfassen, der für jeden Auswahlbereich einen zugeordneten Auskoppelabschnitt aufweist. Von über die Vorderseite auf das diffraktive Element im Anzeigebereich treffender Strahlung kann mindestens ein Teil mittels des diffraktiven Elements in Abhängigkeit des Auswahlbereiches so umgelenkt werden, dass der umgelenkte Teil als eingekoppelte Strahlung im Basiskörper durch Reflexion (oder durch Reflexionen) bis zum Auskoppelbereich propagiert und auf den zugeordneten Auskoppelabschnitt trifft, wobei der Auskoppelbereich von der auf ihn treffenden eingekoppelten Strahlung mindestens einen Teil aus dem Basiskörper so auskoppelt, dass der von einem Auskoppelabschnitt ausgekoppelte Teil auf den zugeordneten Sensorabschnitt der Sensoreinrichtung trifft, der die Intensität der auftreffenden Strahlung laufend misst und der Steuereinrichtung zuführt. Die Steuereinrichtung kann in Abhängigkeit einer Intensitätsänderung, die durch Positionieren eines Objekts vor der Vorderseite des Basiskörpers und vor einem Auswahlbereich des Anzeigebereichs bedingt ist, bestimmen, ob der eine Auswahlbereich ausgewählt wurde.

Somit kann durch die gemessene Intensitätsänderung bestimmt werden, ob, und wenn ja, welcher der Auswahlbereiche des Anzeigebereichs ausgewählt wurde.

Bei der erfindungsgemäßen Lösung kann somit die Annäherung eines Objektes (beispielsweise eines Fingers oder einer Hand) an den Auswahlbereich eine Änderung der Lichtintensität in diesem Bereich bewirken. Damit wird eine Änderung der Lichtintensität auf dem zugeordneten Sensorabschnitt bewirkt. Über beispielsweise die Spannungsveränderung auf dem Sensor kann damit der genaue Ort der Eingabe auf der Anzeigeeinrichtung und/oder der Abstand des Objektes zur Vorderseite des Basiskörpers interpretiert werden. Vorteilhaft ist es, wenn sowohl das diffraktive Element im Anzeigebereich sowie der Auskoppelabschnitt als in den Basiskörper eingebettetes Volumenhologramm ausgebildet sind, die als Ein- und Auskoppelgitter wirken. Zusammen mit dem Basiskörper bilden die Hologramme einen holographischen Wellenleiter. Darin kann Licht einer bestimmten Wellenlänge bzw. spektralen Bandbreite oder Licht eines bestimmten Winkels bzw. Winkelbereiches vom Einkoppelgitter zum Auskoppelgitter geführt werden. Die Führung innerhalb des Basiskörpers erfolgt dabei bevorzugt durch innere Totalreflexion an Vorder- und Rückseite in einem vom Volumenhologramm bestimmten Ablenkwinkel.

Mit dem erfindungsgemäßen Detektorsystem kann ein berührungsloser Flächensensor bereitgestellt und können beispielsweise folgende neue Anwendungsfälle bereitgestellt oder verbessert werden. So ist eine Integration eine Visualisierung hinter einer Scheibe (z.B. Schaufenster) möglich, mit der auch aus kurzer Distanz interagiert werden kann. Es kann ein transparentes, teiltransparentes oder opakes Display erstellt und bedient werden, bei dem die Inhalte (Auswahlbereich) vor, in oder hinter der Displayebene angezeigt werden. Es wird eine Verbesserung der Eingabeerkennung und der Ergonomie verglichen zu anderen gestenerkennenden Kameralösungen erreicht.

Ferner ist eine Bedienung mit Hilfe von Objekten aller Art (leitfähig oder nicht leitfähig) möglich. Es besteht eine geringe Störanfälligkeit bei unterschiedlichen Lichtverhältnissen und es ist keine Datenbank nötig, wie dies z.B. bei einer Spracheingabe der Fall ist. Auch besteht eine große Auswahlmöglichkeit für das Material des transparenten Basiskörpers. Es handelt sich um ein rein optisches System in der Fläche, so dass diverse Funktionsschichten (z.B. mit Lasergravuren, Drähte, usw.) in der Fläche nicht notwendig sind. Es findet auch keine Verschmutzung der Vorderseite des Basiskörpers durch die Bedienung statt, da es sich um eine berührungslöse Bedienung handelt.

Die Anzeigeeinrichtung kann von dem transparenten Basiskörper beabstandet sein oder mit diesem verbunden sein. Ferner kann der Basiskörper in der Anzeigeeinrichtung selbst integriert sein. Die Anzeigeeinrichtung kann als aktive Anzeigeeinrichtung oder als passive Anzeigeeinrichtung ausgebildet sein.

Das diffraktive Elemente im Anzeigebereich kann im transparenten Basiskörper vergraben ausgebildet sein. Bevorzugt ist das diffraktive Element als Volumenhologramm ausgebildet. Natürlich kann das diffraktive Element auch als zweidimensionales Gitter ausgebildet sein. Dabei kann es vergraben im Basiskörper sein oder an der Vorder- oder an der Rückseite ausgebildet sein. Das diffraktive Element kann auch ein Reliefgitter sein.

Gleiches gilt für den Auskoppelbereich. Der Auskoppelbereich kann ein diffraktives Element aufweisen. Das diffraktive Element des Auskoppelbereiches kann in gleicher Weise weitergebildet sein wie das diffraktive Element des Anzeigebereiches. Besonders bevorzugt ist es, wenn sowohl im Anzeigebereich als auch im Auskoppelbereich jeweils ein Volumenhologramm ausgebildet ist.

Der transparente Basiskörper ist bevorzugt als planparallele Platte ausgebildet und kann aus Kunststoff oder Glas hergestellt sein. Es ist jedoch auch möglich, dass die Vorderseite und/oder die Rückseite des transparenten Basiskörpers gekrümmt ausgebildet ist. Ferner ist es möglich, dass die Vorder- und Rückseite plan ausgebildet sind, jedoch nicht parallel zueinander verlaufen, so dass der transparente Basiskörper eine Keilform aufweist.

Der Auskoppelbereich kann so ausgebildet sein, dass er die Strahlung über die Vorderseite, die Rückseite oder die Stirnseite des transparenten Basiskörpers auskoppelt.

Die Auswahlbereiche können in einer ersten Richtung nebeneinander (mit Abstand oder direkt benachbart) angeordnet sein. Des Weiteren können die Auswahlbereiche in einer zweiten Richtung, die verschieden zur ersten Richtung ist, nebeneinander, direkt benachbart oder voneinander beabstandet angeordnet sein.

Gleiches gilt für die Auskoppelabschnitte des Auskoppelbereiches.

Die Linsenfunktion des diffraktiven Elementes kann so ausgebildet sein, dass für jeden Auswahlbereich eine separate Linsenfunktion bereitgestellt ist. Die Brennpunkte dieser Linsenfunktionen liegen bevorzugt in einer Brennebene, die insbesondere vor der Vorderseite liegt.

Ferner kann die Linsenfunktion des Auskoppelbereiches so ausgestaltet sein, dass jeder Auskoppelabschnitt eine Linsenfunktion aufweist. Die Brennpunkte dieser bereitgestellten Linsenfunktionen liegen bevorzugt in der Ebene der Sensoreinrichtung.

Die Beleuchtungseinrichtung kann insbesondere so ausgestaltet sein, dass ein diffraktives Element zur Auskopplung von Beleuchtungsstrahlung im Bereich der Auswahlbereiche vorgesehen ist.

Das diffraktive Element im Bereich mindestens eines Auswahlbereiches und/oder mindestens ein Auskoppelabschnitt (bevorzugt der zugeordnete Auskoppelabschnitt) kann/können eine wellenlängenabhängige Abbildungseigenschaft mit einem Farblängsfehler aufweisen. Darunter wird verstanden, dass für verschiedene Wellenlängen die Lage der Brennpunkte entlang der optischen Achse der Abbildungseigenschaft unterschiedlich ist. Die Sensoreinrichtung kann die Intensität der auftreffenden Strahlen wellenabhängig messen und der Steuereinrichtung zuführen, wobei die Steuereinrichtung in Abhängigkeit der gemessenen wellenlängenabhängigen Intensität den Abstand des Objekts von der Vorderseite des Basiskörpers bestimmt.

Das Detektorsystem ist insbesondere so ausgelegt, dass nur Abstände gemessen bzw. detektiert werden, die größer als Null sind, um eine berührungslose Abstandsdetektion zu ermöglichen.

Die Steuereinrichtung kann in Abhängigkeit des bestimmten Abstandes den Wert eines Mess- und/oder Ausgabeparameters oder eines sonstigen Parameters ändern. Dabei kann es sich z.B. um eine Lautstärke einer Tonausgabe, um die Helligkeit einer Darstellung, um die Empfindlichkeit einer Messgröße oder sonstiges handeln. Durch die Messung des Abstandes kann in vorteilhafter Weise in einfacher Art und Weise die Größe eines Wertes beispielsweise kontinuierlich verstellt bzw. eingestellt werden.

Eine solche Verstellung (bevorzugt kontinuierliche Verstellung) eines Parameters ist auch dadurch realisierbar, dass die mehreren Auswahlbereiche als unterschiedliche Größen des Parameters ausgelegt werden, so dass in Art eines Schiebereglers durch eine Bewegung des Objektes über die Auswahlbereiche die Größeneinstellung durchgeführt wird.

Es versteht sich, dass die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

Nachfolgend wird die Erfindung anhand von Ausführungsbeispielen unter Bezugnahme auf die beigefügten Zeichnungen, die ebenfalls erfindungswesentliche Merkmale offenbaren, noch näher erläutert. Diese Ausführungsbeispiele dienen lediglich der Veranschaulichung und sind nicht als einschränkend auszulegen. Beispielsweise ist eine Beschreibung eines Ausführungsbeispiels mit einer Vielzahl von Elementen oder Komponenten nicht dahingehend auszulegen, dass alle diese Elemente oder Komponenten zur Implementierung notwendig sind. Vielmehr können andere Ausführungsbeispiele auch alternative Elemente und Komponenten, weniger Elemente oder Komponenten oder zusätzliche Elemente oder Komponenten enthalten. Elemente oder Komponenten verschiedener Ausführungsbeispiele können miteinander kombiniert werden, sofern nichts anderes angegeben ist. Modifikationen und Abwandlungen, welche für eines der Ausführungsbeispiele beschrieben werden, können auch auf andere Ausführungsbeispiele anwendbar sein. Zur Vermeidung von Wiederholungen werden gleiche oder einander entsprechende Elemente in verschiedenen Figuren mit gleichen Bezugszeichen bezeichnet und nicht mehrmals erläutert. Von den Figuren zeigen:
- Fig. 1: eine schematische Darstellung einer Ausführungsform des erfindungsgemäßen Detektorsystems;
- Fig. 2: eine Ansicht auf die Vorderseite 7 des Basiskörpers 6 des Detektorsystems 1 in Fig. 1;
- Fig. 3: eine Ansicht auf die Sensoreinrichtung 4 des Detektorsystems von Fig. 1;
- Fig. 4: eine Ansicht auf die Vorderseite eines weiteren Basiskörpers 6 gemäß einer weiteren Ausführungsform des erfindungsgemäßen Detektorsystems 1;
- Fig. 5: eine Ansicht auf die Vorderseite 7 einer weiteren Ausführungsform des Basiskörpers 6 eines weiteren erfindungsgemäßen Detektorsystems 1;
- Fig. 6: eine Seitenansicht des Detektorsystems 1 von Fig. 5;
- Fig. 7: eine schematische Darstellung zur Erläuterung einer weiteren Ausführungsform des erfindungsgemäßen Detektorsystems 1;
- Fig. 8: eine schematische Darstellung zur Erläuterung einer weiteren Ausführungsform des erfindungsgemäßen Detektorsystems 1;
- Fig. 9: eine Ansicht auf die Vorderseite 7 eines transparenten Basiskörpers 6 einer weiteren Ausführungsform des erfindungsgemäßen Detektorsystems 1;
- Fig. 10: eine Seitenansicht des Detektorsystems 1 von Fig. 9;
- Fig. 11: eine Ansicht auf die Vorderseite 7 des Basiskörpers 6 einer weiteren Ausführungsform des erfindungsgemäßen Detektorsystems 1;
- Fig. 12: eine Ansicht auf die Vorderseite 7 des Basiskörpers 6 einer weiteren Ausführungsform des erfindungsgemäßen Detektorsystems 1;
- Fig. 13: eine Ansicht auf die Vorderseite 7 des Basiskörpers 6 einer weiteren Ausführungsform des erfindungsgemäßen Detektorsystems 1;
- Fig. 14: eine Ansicht auf die Vorderseite 7 des Basiskörpers 6 einer weiteren Ausführungsform des erfindungsgemäßen Detektorsystems 1;
- Fig. 15: eine Seitenansicht des Detektorsystems 1 von Fig. 14;
- Fig. 16: eine schematische Darstellung einer weiteren Ausführungsform des erfindungsgemäßen Detektorsystems, und
- Fig. 17: eine schematische Darstellung einer weiteren Ausführungsform des erfindungsgemäßen Detektorsystems.

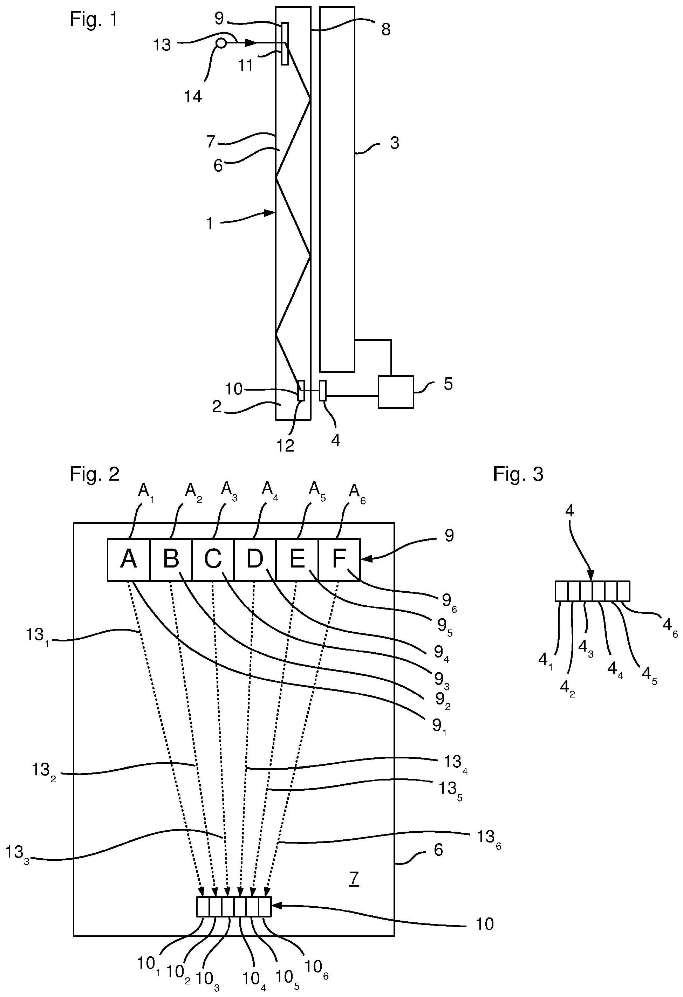

Bei der in Fig. 1 gezeigten Ausführungsform umfasst das erfindungsgemäße Detektorsystem 1 einen Wellenleiter 2, eine Anzeigeeinrichtung 3, eine Sensoreinrichtung 4 und eine Steuereinrichtung 5.

Der Wellenleiter weist einen transparenten Basiskörper 6 mit einer Vorderseite 7 und einer Rückseite 8 auf. Bei dem hier beschriebenen Ausführungsbeispiel ist der Basiskörper 6 als planparallele Platte ausgebildet, so dass sowohl die Vorderseite 7 als auch die Rückseite 8 jeweils plan ist. Der Basiskörper 6 kann beispielsweise aus Glas oder Kunststoff gebildet sein.

Der Basiskörper 6 umfasst einen Einkoppelbereich 9 und einen davon beabstandeten Auskoppelbereich 10, wobei sowohl im Einkoppelbereich 9 aus auch im Auskoppelbereich 10 jeweils ein Volumenhologramm 11, 12 ausgebildet ist.

Wie schematisch in Fig. 1 dargestellt ist, wird von einer Strahlung 13, die über die Vorderseite 7 in den transparenten Basiskörper 6 eintritt und auf das Volumenhologramm 11 des Einkoppelbereichs 9 trifft, mindestens ein Teil mittels des Volumenhologramms 11 so umgelenkt, dass der umgelenkte Teil als eingekoppelte Strahlung durch Reflexionen an Rückseite 8 und Vorderseite 7 bis zum Volumenhologramm 12 des Auskoppelbereichs 11 geführt wird. Die Reflexionen an der Rückseite 8 und der Vorderseite 7 können interne Totalreflexionen sein. Es ist jedoch auch möglich, dass die Vorderseite 7 und die Rückseite 8 teilreflektiv oder reflektiv mindestens im Bereich zur Führung der eingekoppelten Strahlung beschichtet sind.

Von der auf das Volumenhologramm 12 des Auskoppelbereichs 10 treffenden eingekoppelten Strahlung wird mindestens ein Teil so mittels des Volumenhologramms 12 umgelenkt, dass dieser über die Rückseite 8 aus dem transparenten Basiskörper 6 austritt und auf die hinter der Rückseite 8 positionierte Sensoreinrichtung 4 trifft.

Hinter der Rückseite 8 des transparenten Basiskörpers 6 ist ferner die Anzeigeeinrichtung 3 angeordnet, die z.B. ein LCD-Display sein kann. Die Anzeigeeinrichtung ist so ausgebildet und/oder wird mittels der Steuereinrichtung 5 so angesteuert, dass sie im Einkoppelbereich 9 mehrere Auswahlbereiche A₁, A₂, A₃, A₄, A₅, A₆ darstellt. Dies ist in der Ansicht auf die Vorderseite des transparenten Basiskörpers in Fig. 2 durch die Buchstaben A, B, C, D, E und F beispielhaft dargestellt. Jeder der Buchstaben stellt einen einzelnen Auswahlbereich dar. Der um die Buchstaben jeweils eingezeichnete viereckige Rahmen kann auch dargestellt werden oder kann weggelassen werden. Natürlich ist die Darstellung nicht auf die dargestellten Buchstaben beschränkt. Es kann z. B. jedes beliebige Bild, Symbole, Ziffern, mehrere Buchstaben oder Texte dargestellt werden.

Der Einkoppelbereich 9 kann daher auch als Anzeigebereich 9 des Basiskörpers 6 bezeichnet werden, in dem auswählbare Auswahlbereiche so dargestellt werden, dass sie bei Betrachtung der Vorderseite 7 wahrnehmbar sind.

Das Volumenhologramm 11 des Einkoppelbereichs 9 ist so ausgebildet, dass jedem Auswahlbereich A₁-A₆ ein Einkoppelabschnitt 9₁, 9₂, 9₃, 9₄, 9₅ und 9₆ zugeordnet ist. Jedem dieser Einkoppelabschnitte 9₁-9₆ ist ein Auskoppelabschnitt 10₁, 10₂, 10₃, 10₄, 10₅ und 10₆ zugeordnet, auf dem der Teil der gekoppelten Strahlung trifft, der von dem entsprechenden Einkoppelabschnitt 9₁-9₆ umgelenkt wurde, wie durch die gestrichelt eingezeichneten Linien 13₁, 13₂, 13₃, 13₄, 13₅ und 13₆ angedeutet ist.

Wie in Fig. 3 schematisch dargestellt ist, ist die Sensoreinrichtung 4 als Zeilensensor mit sechs Sensorabschnitten 4₁, 4₂, 4₃, 4₄, 4₅ und 4₆ ausgebildet, wobei jeder Sensorabschnitt 4₁-4₆ einem der Auskoppelabschnitte 10₁-10₆ zugeordnet ist. Somit trifft die vom Auskoppelabschnitt 10₁ ausgekoppelte Strahlung auf den Sensorabschnitt 4₁.

Die Sensoreinrichtung 4 misst laufend die Intensität der Sensorabschnitte 4₁-4₆ und führt diese Messergebnisse der Steuereinrichtung 5 zu, die einen Prozessor zur Durchführung der entsprechenden Berechnung und Steuerung aufweist.

Wenn nun ein Benutzer beispielsweise den Auswahlbereich mit dem Buchstaben A auswählen will, kann er seinen Finger 14 vor der Vorderseite 7 des Basiskörpers 6 und vor dem Auswahlbereich mit dem Buchstaben A positionieren (ohne die Vorderseite 7 zu berühren), wodurch eine Änderung der Lichtintensität vor dem Einkoppelabschnitt 9₁ auftritt (es wird weniger Licht über den Einkoppelabschnitt 9₁ eingekoppelt, da der Finger 14 zu einer gewissen Abschattung führt). Durch die Lichteinkopplung über den entsprechenden Einkoppelabschnitt 9₁ und der Führung des eingekoppelten Lichtes 13₁ bis zum Auskoppelabschnitt 10₁, der das Licht auf den Sensorabschnitt 4₁ lenkt, wird der Sensorabschnitt 4₁ eine geringere Lichtintensität messen und dieses Messergebnis an die Steuereinrichtung 5 weitergeben. Die Steuereinrichtung 5 kann aufgrund der verringerten Intensität ermitteln, dass der Auswahlbereich mit dem Buchstaben A ausgewählt wurde.

Somit wird ein berührungsloser Flächensensor bereitgestellt, der universell einsetzbar ist und eine geringe Störanfälligkeit selbst bei unterschiedlichen Lichtverhältnissen aufweist.

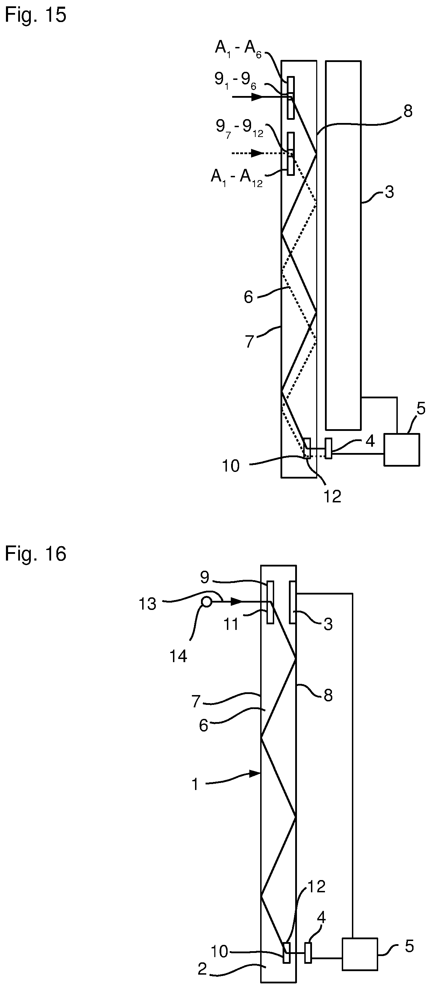

Der transparente Basiskörper 6 kann von der Anzeigeeinrichtung 3 (nachfolgend auch Anzeigevorrichtung 3 genannt) beabstandet sein, wie schematisch in Fig. 1 dargestellt ist. Es ist jedoch auch möglich, dass der Basiskörper 6 mit der Anzeigeeinrichtung 3 verbunden ist. Insbesondere kann die Anzeigeeinrichtung 3 selbst als transparenter Basiskörper 6 genutzt werden. In diesem Fall müssen lediglich die Volumenhologramme 11 und 12 in der Anzeigeeinrichtung 3 ausgebildet werden, so dass dann der transparente Basiskörper 6 durch die Anzeigeeinrichtung 3 verwirklicht ist. Insbesondere kann die Anzeigeeinrichtung 3 ein optoelektronisches Element (beispielsweise ein LCD-Element oder ein OLED-Element) enthalten, das im Basiskörper 6 eingebettet ist, wie schematisch in Figur 16 dargestellt ist. Die bisher beschriebenen Anzeigeeinrichtungen 3 können somit auch als aktive Anzeigeeinrichtungen 3 bezeichnet werden.

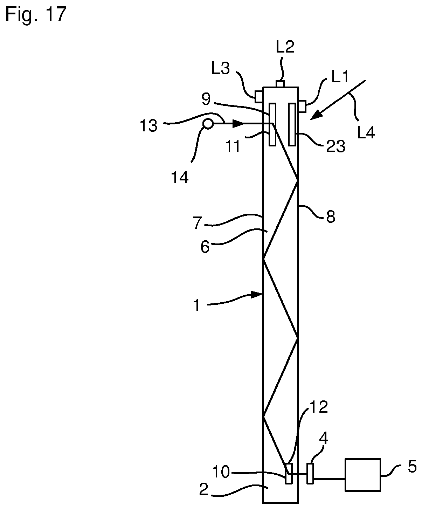

Ferner ist es möglich, für die Anzeigeeinrichtungen 3 ein holografisches Element 23 (z.B. eine holografische Streuscheibe) zu verwenden, die ebenfalls im Basiskörper 6 eingebettet sein kann, wie in Figur 17 schematisch dargestellt ist. Mit dem holografischen Element können dynamische oder statische Inhalte dargestellt werden. Die Beleuchtung (bzw. Rekonstruktion des Hologramms als Teil der Anzeigeeinrichtung 3) kann auf verschiedene Arten realisiert werden. So kann eine aktive Beleuchtung L1 - L3 vorgesehen werden, wobei die Beleuchtung L1 an der Rückseite 8, die Beleuchtung L2 an der Stirnseite und die Beleuchtung L3 an der Vorderseite 7 angeordnet ist. Natürlich ist bevorzugt nur eine der drei Beleuchtungen L1 - L3 vorgesehen. Alternativ kann auch das Hologramm so ausgelegt sein, dass die Beleuchtung mit Sonnenlicht (durch Pfeil L4 angedeutet) realisiert wird. Die Beleuchtung L1 - L3 können als aktive Beleuchtung und die Beleuchtung mit Sonnenlicht kann als passive Beleuchtung bezeichnet werden.

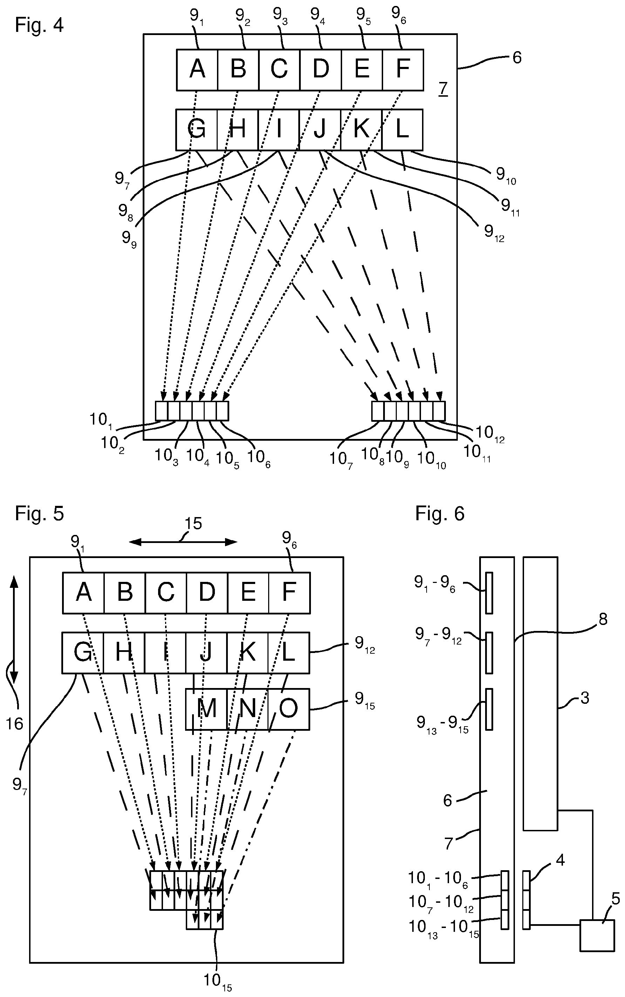

In Fig. 4 ist eine Ausführungsform beschrieben, bei der zwei Mal sechs Einkoppelabschnitte 9₁-9₆ und 9₇, 9₈, 9₉, 9₁₀, 9₁₁ und 9₁₂ vorgesehen sind. Diese zwei Mal sechs Einkoppelabschnitte 9₁-9₆ und 9₇-9₁₂ sind vertikal übereinander (in Propagationsrichtung übereinander) angeordnet. Die zugeordneten zwölf Auskoppelabschnitte 10₁-10₆ sowie 10₇, 10₈, 10₉, 10₁₀, 10₁₁ und 10₁₂ sind hingegen in horizontaler Richtung voneinander beabstandet, wie in Fig. 4 dargestellt ist. Hinter diesen beiden Bereichen von Auskoppelabschnitten 10₁-10₆ und 10₇-10₁₂ sind zwei Bereiche mit jeweils sechs Sensorabschnitten angeordnet, so dass jedem Einkoppelabschnitt 9₁-9₁₂ über die Auskoppelabschnitte 10₁-10₁₂ ein Sensorabschnitt zugeordnet ist. Die Auskoppelabschnitte 10₁-10₆ und 10₇-10₁₂ sind in horizontaler Richtung voneinander beabstandet, um eine Auflösung in vertikaler Richtung (Propagationsrichtung) zu erreichen und möglichst Störungen der Abschnitte des Volumenhologramms 11 des Einkoppelbereiches 9 zu vermeiden. Daher sind die Propagationswinkel zu den Auskoppelabschnitten 10₁-10₁₂ und somit zu den Sensorabschnitten der Sensoreinrichtung 4 von den Einkoppelabschnitten 9₁-9₆ und den Einkoppelabschnitten 9₇-9₁₂ andererseits möglichst unterschiedlich.

Bei der in Fig. 4 gezeigten Lösung sind die Auskoppelabschnitte 10₁-10₁₂ und somit die Sensorabschnitte der Sensoreinrichtung 4 an verschiedenen Orten des transparenten Basiskörpers 6 ausgebildet. Alternativ ist es möglich, innerhalb der Auskoppelabschnitte 10₁-10₁₂ möglichst größere Abstände für die unterschiedlichen vertikalen Eingabemöglichkeiten (Einkoppelabschnitte 9₁-9₆ einerseits und Einkoppelabschnitte 9₇-9₁₂ andererseits) zu wählen. Dies trifft dann natürlich auch auf die Sensorabschnitte der Sensoreinrichtung 4 zu. Durch den Abgleich der Spannungsunterschiede auf den einzelnen Sensorabschnitten kann dann sicher der korrekte Eingabewert erkannt werden.

In Fig. 5 ist ein Ausführungsbeispiel gezeigt, bei dem die Sensoreinrichtung 4 einen 2D-RGB-Sensor aufweist, der hinter der Rückseite 8 positioniert ist, wie in Fig. 6 dargestellt ist. Bei dieser Ausführungsform werden die unterschiedlichen Auswahlbereiche in der waagerechten Richtung (Doppelpfeil 15) wie bei der in Verbindung mit Fig. 4 beschriebenen Ausführungsform über den Propagationswinkel aufgelöst. Die unterschiedlichen Auswahlbereiche in vertikaler Richtung (Doppelpfeil 16) werden über die Wellenlängen aufgelöst. Um dies zu realisieren, ist das Volumenhologramm 11 des Einkoppelbereichs 9 so gefertigt, dass es das einfallende Licht entsprechend der Position in waagerechter und senkrechter Richtung in der Art beugt, dass für jeden Auswahlbereich (und somit für jeden Einkoppelabschnitt 9₁-9₁₅) eine entsprechend unterschiedliche Kombination aus Propagationswinkel und Wellenlänge beim Auskoppelbereich 10 bzw. den Auskoppelabschnitten 10₁-10₁₅ und somit bei den Sensorabschnitten der Sensoreinrichtung 4 ankommt. Die Steuereinrichtung 5 kann dann die entsprechenden Werte der Sensoreinrichtung 4 interpretieren.

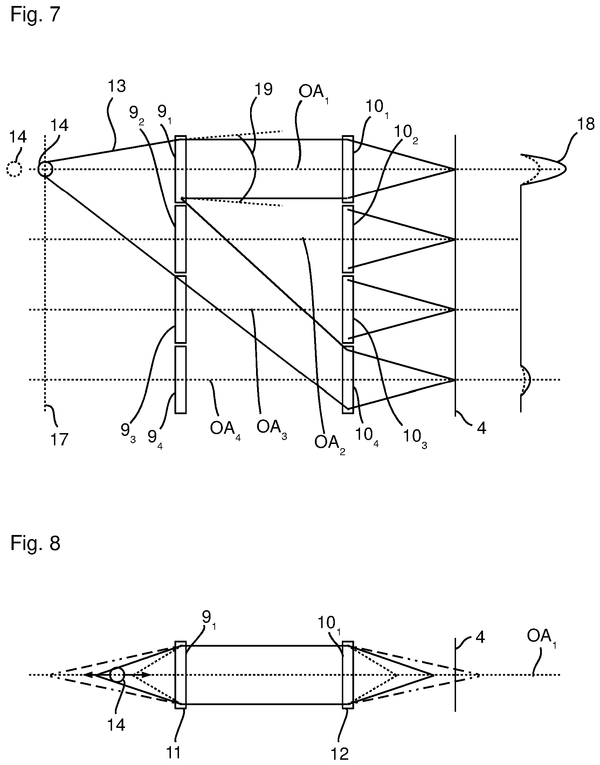

Bei der in Fig. 7 gezeigten Ausführungsform wird zur Eingabeerkennung eine einbelichtete Linsenfunktion genutzt, wobei diese bevorzugt im Volumenhologramm 12 des Auskoppelbereiches 10 integriert ist. Über die Belichtung der Volumenholgramme kann man die Selektivität des Objektpunktes einstellen, indem man in das Volumenhologramm 12 des Auskoppelbereichs 10 eine starke Winkelabhängigkeit einbelichtet. Dafür integriert man in jedem Auskoppelabschnitt 10₁-10₁₂ eine holographisch einbelichtete Linse, deren Wirkung in der schematischen Darstellung in Fig. 7 angedeutet ist. Die Brennweite dieser einbelichteten Linse liegt in einer Brennebene 17 vor der Vorderseite 7 des transparenten Basiskörpers 6 und definiert den Abstand des zu detektierenden Gegenstandes 14 zur Vorderseite 7, in dem der Gegenstand 14 ideal auf die Sensoreinrichtung 4 abgebildet ist. In Fig. 7 ist ferner noch die Intensitätsverteilung 18 schematisch für jeden Auskoppelabschnitt 10₁-10₄ für den Gegenstand 14 bei Positionierung innerhalb der Brennebene 17 (durchgezogene Linie) und bei Positionierung vor der Brennebene 17 (gestrichelte Linie) dargestellt. Auf der Sensoreinrichtung 4 entstehen somit unterschiedliche Kontrastflächen (Spots), die den einzelnen Auswahlbereichen (Einkoppelabschnitten 9₁-9₄) zugeordnet sind. Kommt ein Gegenstand 14 in die Nähe der Brennebene 17, so werden an der Sensoreinrichtung 4 Intensitätsänderungen registriert. Somit kann eine örtliche Auflösung der Eingabe erkannt werden. Mit der Festlegung eines Schwellwertes für die Intensität im Brennpunkt kann die Eingabe für eine Anwendung ausgeführt werden. Wie in Fig. 7 schematisch dargestellt ist, ist die Lichtintensität bzw. der Kontrast auf der Sensoreinrichtung 4 umso größer, je näher der Gegenstand 14 der Brennebene 17 ist. Die Aberrationen nehmen mit steigendem Abstand des Gegenstandes 14 von der jeweiligen optischen Achse OA₁, OA₂, OA₃ und OA₄ zu. Ferner ist in Fig. 7 noch der sensitive Winkelbereich 19 des Einkoppelabschnitts 9₁ eingezeichnet.

Diese beschriebene Kontraständerung mit Abstand zur Brennebene 17 kann auch in der Art ausgewertet werden, dass dadurch die Entfernung des Gegenstandes 14 zur Brennebene 17 (und somit auch zur Vorderseite 7) detektiert wird. Diese Änderung des Abstands zur Brennebene 17 (bzw. zur Vorderseite 7) kann als Eingabegröße zur Einstellung eines Parameters, wie z.B. zur Regelung der Lautstärke einer Tonausgabe werden. So kann man z.B. die Lautstärke erhöhen, wenn der Gegenstand 14 zur Brennebene 17 hin bewegt wird und damit der Abstand zur Brennebene 17 abnimmt. Auch sonstige Parameter können so gesteuert werden, wie z.B. die Helligkeit der Darstellung im Anzeigebereich oder sonstige Parameter für die Anzeige.

Die Erkennung der Entfernung des Gegenstandes 14 zur Vorderseite 7 kann auch durch eine spektrale Auflösung erfolgen.

Dazu ist, wie schematisch in Fig. 8 dargestellt ist, sowohl das Volumenhologramm 11 des Einkoppelabschnitts 9₁ als auch das Volumenhologramm 12 des Auskoppelabschnitts 10₁ jeweils mit einer Linsenfunktion ausgebildet. Je nach Spektralwert bzw. Wellenlänge ist die Brennebene des Volumenhologramms 11 für den Einkoppelabschnitt 9₁ unterschiedlich weit weg von der Vorderseite 7 des transparenten Basiskörpers 6. Dabei nimmt der Abstand von Blau zu Grün zu Rot und Infrarot (insbesondere NIR) ab. Wenn der Einkoppelbereich 9 aktiv beleuchtet und die Wellenlänge der Beleuchtung bekannt ist, ist auch die Brennebene und somit der Abstand zur Vorderseite 7 des transparenten Basiskörpers 6 bekannt.

Die Linsenfunktion im Volumenhologramm 12 des Auskoppelabschnitts 10₁ weist die gleiche spektrale Charakteristik auf, so dass der Abstand zur Rückseite 8 von Blau zu Grün zu Rot und Infrarot abnimmt.

Die Sensoreinrichtung 4 ist als spektral selektive Sensoreinrichtung 4 ausgebildet und kann z.B. einen RGB-Sensor umfassen. Über die Intensitätswerte in Abhängigkeit der entsprechenden Wellenlängen kann dann die Steuereinrichtung 5 die Auswahl des entsprechenden Einkoppelabschnitts 9₁ erkennen. Zusätzlich oder alternativ kann eine Detektion des Abstands des Gegenstands 14 zur Vorderseite 7 durchgeführt werden, wodurch wiederum ein Parameter (wie z.B. die Lautstärke) gesteuert werden kann.

Bis jetzt wurden die Hologramme 11 und 12 stets als Volumenhologramme beschrieben. Natürlich können unterschiedliche Hologrammtypen eingesetzt werden. Insbesondere können diffraktive Elemente und insbesondere Reliefgitter genutzt werden. Bei der Verwendung von Volumengittern sowie Volumenhologrammen steht jedoch der Vorteil der Selektivität bei Winkel und Wellenlänge. Durch die Filterfunktion kann damit Störlicht (Strahlung, die für die Funktion der Lösung irrelevant ist) nicht eingekoppelt und/oder nicht zur Sensoreinrichtung 4 weitergeleitet werden. Dies kann zu höherer Präzision und Robustheit beitragen.

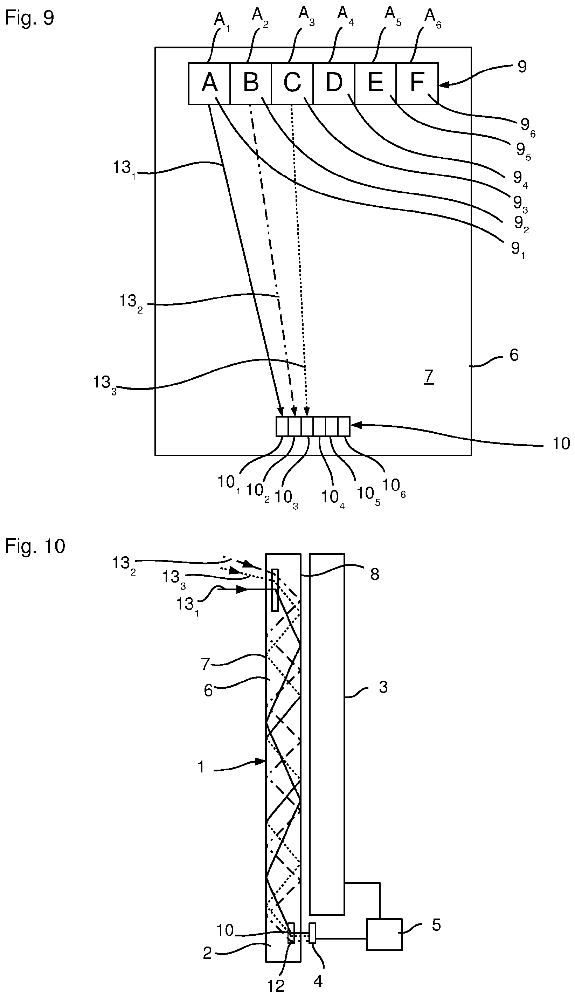

Bei den bisher beschriebenen Ausführungsformen finden sich die Auswahlbereiche A-F nebeneinander. Störungen (z.B. durch Streulicht) können reduziert werden, wenn jeder Auswahlbereich ein unterschiedliches Einkoppelgitter besitzt und die Propagationswinkel benachbarter Auswahlbereiche möglichst unterschiedlich groß gewählt werden, wie nachfolgend schematisch für die Auswahlbereiche der Buchstaben A, B und C in Fig. 9 und 10 dargestellt ist.

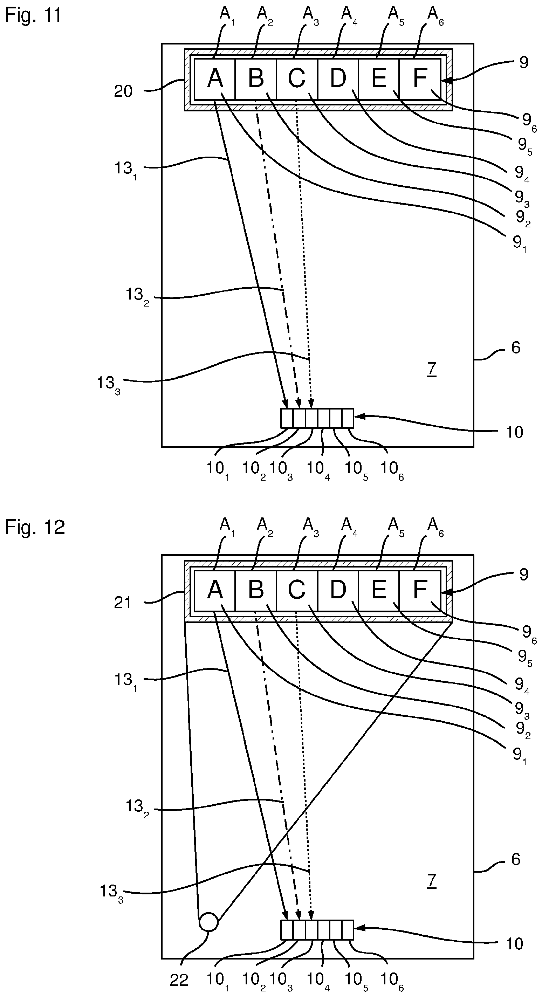

Eine weitere Möglichkeit zur Reduzierung von Störungen wird in Verbindung mit Fig. 11 beschrieben. Hier wird der Gegenstand 14, mit dem die Eingabe erfolgt, aus der Displayebene heraus aktiv beleuchtet. Das reflektierte Licht kann aufgefangen und zur Selektion der Eingabe genutzt werden. Somit werden Störungen durch möglicherweise ungewollte Verschattung reduziert. Weiterhin ist hiermit eine Anwendung bei Dunkelheit möglich.

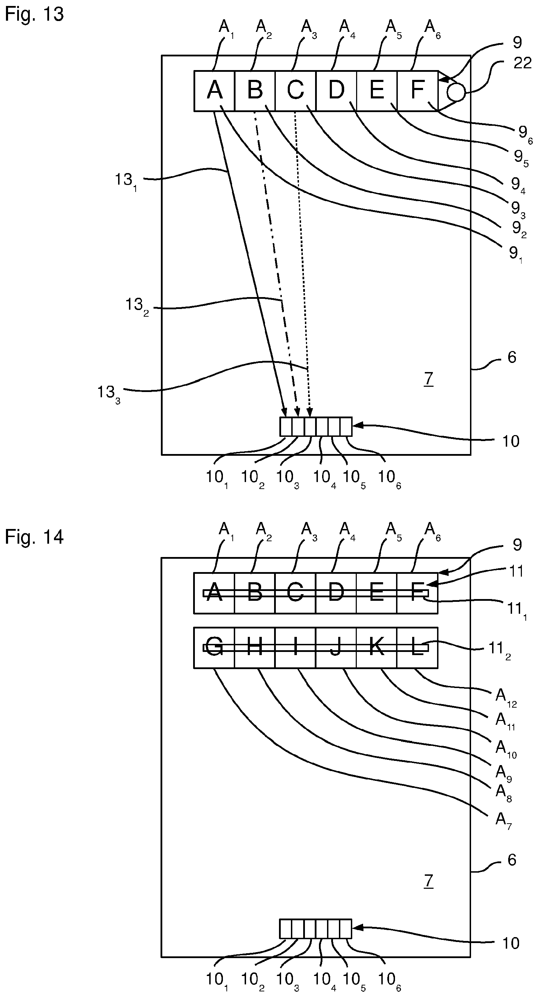

Die aktive Beleuchtung kann z.B. durch einen LED-Rahmen 20 um den Einkoppelbereich 9 realisiert werden (Fig. 11). Es kann aber auch ein zweites Hologramm 21 um den Einkoppelbereich 9 (Fig. 12) oder unter dem Volumenhologramm 11 des Einkoppelbereichs 9 (Fig. 13) dafür verwendet werden, wobei das zweite Hologramm 21 beispielsweise Weißlicht auskoppeln kann, welches von einer definierten Stelle 22 des transparenten Basiskörpers 6 eingekoppelt wird. Dabei muss lediglich darauf geachtet werden, dass sich die propagierenden Wellen des zweiten Hologramms 21 und des Volumenhologramms 11 des Einkoppelbereichs 9 nicht gegenseitig stören. Durch die Beleuchtungsfunktion aus einer mikrooptischen Struktur im transparenten Basiskörper 6 heraus kann der transparente Basiskörper 6 selbst transparent bleiben.

Die aktive Beleuchtung kann auch durch Beleuchtung der Auswahlbereiche auf der Vorderseite 7 aus dem Basiskörper 6 heraus stattfinden. Dabei kann die Quelle für das eingekoppelte Licht örtlich unterschiedlich gewählt werden, wie schematisch in Fig. 13 dargestellt ist.

Zur Optimierung der Strahlenführung und Anordnung der Propagationswinkel muss das Volumenhologramm 11 für den Einkoppelbereich 9 nicht die gesamte Fläche der Auswahlbereiche abdecken, sondern können auch sehr schmal sein, wie in Fig. 14 angedeutet ist. Hierfür kann ein durch eine Planwelle einbelichtetes Einkoppelgitter 11 in mehrere Streifen 11₁, 11₂ geteilt werden, welche dann zum Einkoppeln der jeweiligen Auswahlbereiche in vertikaler Richtung verwendet werden können. Dies hat den Zweck, dass die Strahlen nach dem Einkoppeln auf ihrem Weg zum Auskoppelbereich 10 kein weiteres Einkoppelgitter 11 treffen, da sie sonst interferieren würden und so an der Sensoreinrichtung 4 nicht wieder aufgelöst werden können. Durch die Teilung des Einkoppelgitters 11 in Einkoppelstreifen 11₁, 11₂ können größere Flächen im transparenten Basisbereich 6 funktionalisiert und Eingaben zuverlässig ausgelesen werden. Weiterhin wird es einfacher, geeignete Propagationswinkel für den Transport der Strahlung zum Auskoppelbereich 10 zu finden und zur Detektion können auch mehrere Zeilen im Einkoppelbereich 9 nur ein Auskoppelgitter mit fotosensitivem Chip (Sensoreinrichtung 4) verwenden.

Damit bei der geschilderten Ausführungsform ein komplettes Bild an der Sensoreinrichtung 4 des Auskoppelgitters 12 resultiert, darf die vertikale Höhe des Einkoppelgitters 11 nur gleich groß zu dem der Sensoreinrichtung 4 sein. Um bei unterschiedlichen Höhen dennoch eine optimale Auflösung zu erreichen, kann in das Auskoppelgitter 12 eine Linsenfunktion einbelichtet werden, die dafür sorgt, dass die Strahlung der einzelnen Einkoppelstreifen 11₁, 11₂ des Einkoppelgitters 11 wieder als Gesamtbild in richtiger Skalierung über das Auskoppelgitter auf die Sensoreinrichtung 4 treffen (wie schematisch in Fig. 16 dargestellt ist).

Im Fall von Störlicht kann es bei dem hier beschriebenen Detektorsystem 1 zu Fehlinterpretationen beim Auswerten der Lichtintensitätsänderung auf der Sensoreinrichtung 4 kommen. Um dies zu reduzieren, kann die Steuereinrichtung 5 Lichtwerte aller Auswahlbereiche miteinander vergleichen und sich nicht ändernde Werte über die Laufzeit als statische Werte festlegen. Diese Werte können bei der Auswertung der Intensitätsänderungen vernachlässigt werde. Somit können Lichtwerte, die nicht zur Anwendung gehören, als Hintergrundrauschen herausgerechnet und die eigentliche Berechnung der Intensitätsänderung zur Identifizierung einer Eingabe wird zuverlässiger.

Eine weitere Möglichkeit die Robustheit des Detektorsystems 1 zu verbessern, ist eine Linsenfunktion am Einkoppelgitter und Auskoppelgitter zu belichten. Somit können Intensitätsunterschiede sehr viel besser registriert werden und Falschinterpretationen in der Eingabe können reduziert werde.

Weiterhin kann bei einer einbelichteten Linsenfunktion am Einkoppelgitter das Licht vom Einkoppelgitter zum Auskoppelgitter parallel bzw. als paralleles Strahlenbündel geführt werden. Somit geht weniger Licht auf dem Weg zur Sensoreinrichtung 4 verloren und Störlicht wird reduziert.

Nähert man sich mit einem Gegenstand 14 an einen Auswahlbereich, so kommt am Auskoppelgitter in einem bestimmten Winkelbereich eine bestimmte Lichtintensitätsänderung an (bei aktiver Beleuchtung mehr Licht; bei passiver Beleuchtung weniger Licht). Das Volumenhologramm mit Linsenfunktion ist nur für einen Winkelbereich effizient. Auf der Sensoreinrichtung kommt für den Auswahlbereich auf der Sensoreinrichtung eine starke Intensitätsänderung an. Benachbarte Auswahlbereiche erreichen auf der Sensoreinrichtung keine oder nur wenige Intensitätsänderungen, da für die der Winkelbereich nicht effizient ist.

## Patentansprüche

1. Detektorsystem mit
einem Wellenleiter (2), der einen transparenten Basiskörper (6) mit einer Vorderseite (7) und einer Rückseite (8) aufweist,
einer Anzeigeeinrichtung (3), die mehrere Auswahlbereiche (A₁, A₂, A₃, A₄, A₅, A₆) so darstellt, dass sie in einem Anzeigebereich (9) des Basiskörpers (6) bei Betrachtung der Vorderseite (7) wahrnehmbar sind,
einer Sensoreinrichtung (4), die für jeden Auswahlbereich (A₁-A₆) einen zugeordneten Sensorabschnitt (4₁-4₆) aufweist, und
einer Steuereinrichtung (5),
wobei der Basiskörper (6) ein diffraktives Element im Anzeigebereich (9) und einen vom Anzeigebereich (9) beabstandeten Auskoppelbereich (10), der für jeden Auswahlbereich (A₁-A₆) einen zugeordneten Auskoppelabschnitt (10₁-10₆) aufweist, umfasst,
wobei von über die Vorderseite (7) auf das diffraktive Element (11) im Anzeigebereich (9) treffender Strahlung mindestens ein Teil mittels des diffraktiven Elements (11) in Abhängigkeit des Auswahlbereiches (A₁-A₆) so umgelenkt wird, dass der umgelenkte Teil als eingekoppelte Strahlung im Basiskörper (6) durch Reflexion bis zum Auskoppelbereich (10) propagiert und auf den zugeordneten Auskoppelabschnitt (10₁-10₆) des Auskoppelbereichs (10) trifft,
wobei der Auskoppelbereich (10) von der auf ihn treffenden eingekoppelten Strahlung mindestens einen Teil aus dem Basiskörper (6) so auskoppelt, dass der von einem Auskoppelabschnitt (10₁-10₆) ausgekoppelte Teil auf den zugeordneten Sensorabschnitt (4₁-4₆) der Sensoreinrichtung (4) trifft, der die Intensität der auftreffenden Strahlung laufend misst und der Steuereinrichtung (5) zuführt,
wobei die Steuereinrichtung (5) in Abhängigkeit einer Intensitätsänderung, die durch Positionieren eines Objektes (14) vor der Vorderseite (7) des Basiskörpers (6) und vor einem Auswahlbereich des Anzeigebereichs (9) bedingt ist, bestimmt, ob der eine Auswahlbereich ausgewählt wurde.

2. Detektorsystem nach Anspruch 1,
wobei das diffraktive Element als Volumenhologramm ausgebildet ist.

3. Detektorsystem nach einem der obigen Ansprüche,
wobei das diffraktive Element (9) eine Linsenfunktion aufweist.

4. Detektorsystem nach Anspruch 3, wobei die Linsenfunktion des diffraktiven Elementes (9) so ausgelegt ist, dass die eingekoppelte Strahlung als paralleles Strahlenbündel im Basiskörper (6) propagiert.

5. Detektorsystem nach einem der obigen Ansprüche,
wobei der Auskoppelbereich ein Volumenhologramm aufweist.

6. Detektorsystem nach einem der obigen Ansprüche,
wobei der Auskoppelbereich eine Linsenfunktion aufweist.

7. Detektorsystem nach einem der obigen Ansprüche,
wobei die Umlenkung mittels des diffraktiven Elementes (11) in Abhängigkeit des Auswahlbereiches (A₁-A₆) durch unterschiedliche Propagationswinkel innerhalb des transparenten Basiskörpers (6) und/oder unterschiedliche umgelenkte Wellenlängen unterscheidet.

8. Detektorsystem nach einem der obigen Ansprüche,
wobei das diffraktive Element für jeden Auswahlbereich (A₁-A₆) einen Einkoppelabschnitt (9₁-9₆) aufweist, der eine geringere flächige Ausdehnung besitzt als der zugeordnete Auswahlbereich (A₁-A₆).

9. Detektorsystem nach einem der obigen Ansprüche,
wobei eine Beleuchtungseinrichtung vorgesehen ist, die das vor der Vorderseite (7) zu positionierende Objekt (14) aktiv beleuchtet.

10. Detektorsystem nach Anspruch 9,
wobei die Beleuchtungseinrichtung so ausgebildet ist, dass sie das Objekt (14) aus dem Basiskörper (6) heraus beleuchtet.

11. Detektorsystem nach einem der obigen Ansprüche,
wobei die Steuereinrichtung (5) in Abhängigkeit der gemessenen Intensität den Abstand des Objekts (14) von der Vorderseite (7) ermittelt.

12. Detektorsystem nach einem der obigen Ansprüche,
wobei die Steuereinrichtung in Abhängigkeit des bestimmten Auswahlbereichs die Anzeigeeinrichtung (3) so ansteuert, dass die Anzeigeeinrichtung (3) ihre Darstellung ändert, und/oder den Wert eines Mess- und Ausgabeparameters ändert.

## Claims

1. Detector system having
a waveguide (2) that comprises a transparent base body (6) having a front (7) and a rear (8),
a display device (3) that shows multiple selection regions (A₁, A₂, A₃, A₄, A₅, A₆) in such a way that they can be seen in a display region (9) of the base body (6) when the front (7) is viewed,
a sensor device (4) that comprises an assigned sensor section (4₁-4₆) for each selection region (A₁-A₆), and
a control device (5),
wherein the base body (6) includes a diffractive element in the display region (9) and a decoupling region (10) that is spaced apart from the display region (9) and comprises an assigned decoupling section (10₁-10₆) for each selection region (A₁-A₆),
wherein at least a portion of radiation that is incident on the diffractive element (11) in the display region (9) via the front (7) is deflected by means of the diffractive element (11) on the basis of the selection region (A₁-A₆) in such a way that the deflected portion propagates as coupled-in radiation in the base body (6) by reflection as far as the decoupling region (10) and is incident on the assigned decoupling section (10₁-10₆) of the decoupling region (10),
wherein the decoupling region (10) decouples at least a portion of the coupled-in radiation that is incident on it from the base body (6) in such a way that the portion decoupled by a decoupling section (10₁-10₆) is incident on the assigned sensor section (4₁-4₆) of the sensor device (4), which section continuously measures the intensity of the incident radiation and supplies it to the control device (5),
the control device (5) taking a change in intensity caused by an object (14) being positioned in front of the front (7) of the base body (6) and in front of a selection region of the display region (9) as a basis for determining whether the selection region has been selected.

2. Detector system according to Claim 1,
wherein the diffractive element is in the form of a volume hologram.

3. Detector system according to one of the above claims,
wherein the diffractive element (9) comprises a lens element function.

4. Detector system according to Claim 3, wherein the lens element function of the diffractive element (9) is designed in such a way that the coupled-in radiation propagates in the base body (6) as a parallel pencil of rays.

5. Detector system according to one of the above claims,
wherein the decoupling region comprises a volume hologram.

6. Detector system according to one of the above claims,
wherein the decoupling region comprises a lens element function.

7. Detector system according to one of the above claims,
wherein the deflection by means of the diffractive element (11) on the basis of the selection region (A₁-A₆) differs by different propagation angles within the transparent base body (6) and/or different deflected wavelengths.

8. Detector system according to one of the above claims,
wherein the diffractive element for each selection region (A₁-A₆) comprises a coupling section (9₁-9₆) that has a smaller two-dimensional extent than the assigned selection region (A₁-A₆).

9. Detector system according to one of the above claims,
wherein there is provision for an illumination device that actively illuminates the object (14) to be positioned in front of the front (7).

10. Detector system according to Claim 9,
wherein the illumination device is designed in such a way that it illuminates the object (14) from the base body (6).

11. Detector system according to one of the above claims,
wherein the control device (5) takes the measured intensity as a basis for ascertaining the distance of the object (14) from the front (7).

12. Detector system according to one of the above claims,
wherein the control device takes the determined selection region as a basis for controlling the display device (3) in such a way that the display device (3) changes its display, and/or changes the value of a measurement parameter and output parameter.

## Revendications

1. Système détecteur avec
un guide d'ondes (2), qui comporte un corps de base (6) transparent avec un côté avant (7) et un côté arrière (8),
un dispositif d'affichage (3), qui représente plusieurs zones de sélection (A₁, A₂, A₃, A₄, A₅, A₆) de telle sorte qu'elles peuvent être vues dans une zone d'affichage (9) du corps de base (6) par observation du côté avant (7), un dispositif capteur (4), qui comporte une section de capteur (4₁-4₆) associée pour chaque zone de sélection (A₁-A₆), et
un dispositif de commande (5),
le corps de base (6) comprenant un élément diffractif dans la zone d'affichage (9) et une zone de découplage (10) espacée de la zone d'affichage (9), qui comporte une section de découplage (10₁-10₆) associée pour chaque zone de sélection (A₁-A₆),
au moins une partie du rayonnement incident sur l'élément diffractif (11) dans la zone d'affichage (9) par le côté avant (7) étant déviée au moyen de l'élément diffractif (11) en fonction de la zone de sélection (A₁-A₆) de telle sorte que la partie déviée se propage en tant que rayonnement injecté dans le corps de base (6) par réflexion jusqu'à la zone de découplage (10) et est incidente sur la section de découplage (10₁-10₆) associée de la zone de découplage (10),
la zone de découplage (10) découplant au moins une partie du rayonnement injecté incident sur celle-ci hors du corps de base (6) de telle sorte que la partie découplée par une section de découplage (10₁-10₆) arrive sur la section de capteur (4₁-4₆) associée du dispositif capteur (4), qui mesure en continu l'intensité du rayonnement incident et l'envoie au dispositif de commande (5),
le dispositif de commande (5) définissant si la zone de sélection a été sélectionnée en fonction d'un changement d'intensité qui est lié au positionnement d'un objet (14) devant le côté avant (7) du corps de base (6) et devant une zone de sélection de la zone d'affichage (9).

2. Système détecteur selon la revendication 1, l'élément diffractif étant formé comme un hologramme volumique.

3. Système détecteur selon l'une des revendications précédentes,
l'élément diffractif (9) présentant une fonction de lentille.

4. Système détecteur selon la revendication 3, la fonction de lentille de l'élément diffractif (9) étant conçue de telle sorte que le rayonnement injecté se propage sous la forme d'un faisceau de rayons parallèle dans le corps de base (6).

5. Système détecteur selon l'une des revendications précédentes,
la zone de découplage comportant un hologramme volumique.

6. Système détecteur selon l'une des revendications précédentes,
la zone de découplage de sortie présentant une fonction de lentille.

7. Système détecteur selon l'une des revendications précédentes,
la déviation au moyen de l'élément diffractif (11) se distinguant, en fonction de la zone de sélection (A₁-A₆), par différents angles de propagation à l'intérieur du corps de base (6) transparent et/ou par différentes longueurs d'onde déviées.

8. Système détecteur selon l'une des revendications précédentes,
l'élément diffractif comportant, pour chaque zone de sélection (A₁-A₆), une section d'injection (9₁-9₆), qui possède une extension de surface plus petite que la zone de sélection (A₁-A₆) associée.

9. Système détecteur selon l'une des revendications précédentes,
un dispositif d'éclairage étant prévu, qui éclaire activement l'objet (14) à positionner devant le côté avant (7).

10. Système détecteur selon la revendication 9,
le dispositif d'éclairage étant formé de telle sorte qu'il éclaire l'objet (14) hors du corps de base (6).

11. Système détecteur selon l'une des revendications précédentes,
le dispositif de commande (5) déterminant la distance entre l'objet (14) par rapport au côté avant (7) en fonction de l'intensité mesurée.

12. Système détecteur selon l'une des revendications précédentes,
le dispositif de commande pilotant le dispositif d'affichage (3) en fonction de la zone de sélection définie de telle sorte que le dispositif d'affichage (3) modifie sa représentation et/ou modifie la valeur d'un paramètre de mesure et de sortie.
